(19) **Europäisches Patentamt / European Patent Office / Office européen des brevets**

(11) **EP 2 867 748 B1**

(12) **FASCICULE DE BREVET EUROPEEN**

(45) Date de publication et mention de la délivrance du brevet:
**10.04.2019 Bulletin 2019/15**

(21) Numéro de dépôt: **13713110.8**

(22) Date de dépôt: **18.03.2013**

(51) Int Cl.:
***G06F 3/02*** *(2006.01)*

(86) Numéro de dépôt international:
**PCT/EP2013/055550**

(87) Numéro de publication internationale:
**WO 2013/135906 (19.09.2013 Gazette 2013/38)**

(54) **PROCEDE POUR DETERMINER L'ACTIVATION D'AU MOINS UNE TOUCHE D'UN DISPOSITIF MULTITOUCHES**

VERFAHREN ZUR FESTSTELLUNG DER BETÄTIGUNG VON ZUMINDEST EINEM SCHLÜSSEL EINER VORRICHTUNG MIT MEHREREN SCHLÜSSELN

METHOD FOR DETERMINING WHETHER AT LEAST ONE KEY OF A DEVICE HAVING MULTIPLE KEYS HAS BEEN ACTUATED

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.03.2012 FR 1200809**

(43) Date de publication de la demande:
**06.05.2015 Bulletin 2015/19**

(73) Titulaire: **Aptiv Technologies Limited St. Michael (BB)**

(72) Inventeur: **GRANDEMANGE, Eric F-67000 Strasbourg (FR)**

(74) Mandataire: **Robert, Vincent et al Aptiv Services France SAS Aptiv EMEA Patent Department Bâtiment Le Raspail - Paris Nord 2 22, avenue des Nations CS 65059 Villepinte 95972 Roissy CDG Cedex (FR)**

(56) Documents cités:
**WO-A1-2012/004370 US-A- 5 440 237 US-A1- 2009 066 673**

**Description**

DOMAINE TECHNIQUE

La présente invention concerne de manière générale un procédé ou algorithme pour déterminer la ou les touches d'un dispositif multitouches sur laquelle/lesquelles un utilisateur a appuyé. L'invention s'applique aux dispositifs multitouches et plus particulièrement aux dispositifs multitouches ou appareils comprenant des capteurs de force ayant une résistance sensible à une force appliquée (FSR, en anglais Force Sensitive Resistor) et opérant dans une condition pré-chargée, et dans lesquels l'activation d'une touche est déterminée lorsqu'une force captée est supérieure à un seuil de force prédéterminé.

ARRIERE-PLAN TECHNOLOGIQUE

Il existe des dispositifs multitouches comprenant une pluralité de touches qui sont activées par des capteurs de force FSR dont la résistance varie en fonction de la force appliquée sur la touche et le capteur. Le dispositif inclut un algorithme permettant de déterminer qu'une touche a été pressée et activée lorsque l'amplitude de la force appliquée est supérieure à un seuil de force prédéterminé.

Un algorithme actuellement utilisé est basé sur un filtre passe-haut ayant une constante de temps longue (16 échantillons pour une période d'échantillonnage de 20msec). La valeur sortant de ce filtre, qui dépend de la vélocité et de la force de l'actionnement, est comparée à des seuils pour détecter n'importe quel changement du capteur.

Un autre algorithme actuellement utilisé est basé sur une tache logicielle (période longue) responsable de calculer un état sans activité pour les touches. Sur la base du niveau de l'état sans activité évalué, une deuxième tache logicielle (période rapide) compare un niveau de pression actuel au niveau de l'état sans activité recalculé.

Toutefois, il arrive que les algorithmes actuellement utilisés ne permettent pas d'identifier correctement les touches pressées lorsqu'un utilisateur appuie, d'une manière enchaînée, sur plusieurs touches différentes d'un dispositif multitouches. Lorsqu'un utilisateur appuie sur plusieurs touches différentes, une pression peut être appliquée aux capteurs de force d'autres touches sur lesquelles l'utilisateur n'a pas directement appuyé (particulièrement lorsque l'espace entre les touches est faible), et ces capteurs de force fournissent alors des signaux au dispositif indiquant que leurs touches ont été pressées alors qu'en réalité l'utilisateur n'a fait qu'appuyer sur des touches voisines.

En outre, lorsque l'utilisateur appuie fortement et/ou pendant longtemps sur une touche, les capteurs de force des touches voisines peuvent recevoir une pression importante et fournissent un signal au dispositif indiquant que leurs touches ont été pressées.

Ainsi, le dispositif ne détermine pas correctement les touches qui ont été vraiment touchées et pressées par l'utilisateur, et ne détermine donc pas correctement les touches que l'utilisateur voulait activer.

Le document WO 2012/004370 A1 décrit un algorithme de détection d'actionneur de bouton poussoir. Il est notamment décrit que l'influence mécanique entre les touches peut être réduite par une caractérisation quantitative du transfert d'une quantité de tension (ou fréquence) d'une touche à une autre, et par une correction, sur la base de cette caractérisation quantitative, de la valeur de seuil ($\Delta_{vp}$ ou $\Delta_{fp}$) ou de la quantité oisive ($V_{idle}$ ou $f_{idle}$) des touches utilisées pour déterminer si une touche est activée ou non.

Le document US 2009/066673 A1 décrit une manière d'ajuster des valeurs fournies par des capteurs FSR d'un écran multicouches afin de compenser une contribution provenant de la structure mécanique de l'écran multicouche. Une table de compensation est établie, comportant des valeurs de compensation correspondant aux coordonnées x,y de l'écran. Lorsque l'écran est touché, un logiciel prend en compte les valeurs de la table pour ajuster les valeurs fournies par des capteurs FSR. Afin d'établir cette table de compensation, un ensemble de points sur l'écran de coordonnées x,y différentes est choisi. Une force est appliquée à chaque point et sa position est calculée sur la base des valeurs fournies par des capteurs FSR et est comparée à sa vraie position. La différence entre la position calculée et la vraie position est enregistrée dans la table de compensation pour chaque point choisi. C'est ensuite la valeur de cette différence entre la position calculée et la vraie position qui est utilisée pour compenser la contribution provenant de la structure mécanique de l'écran multitouches (§0114 à §0116).

RESUME DE L'INVENTION

Un but de la présente invention est de répondre aux inconvénients mentionnés ci-dessus en fournissant un procédé pour déterminer la ou les touches d'un dispositif multitouches sur laquelle/lesquelles un utilisateur a vraiment appuyé.

Dans ce but, un premier aspect de la présente invention concerne un procédé selon la revendication 1.

Un tel procédé permet d'éliminer les forces parasites appliquées aux capteurs qui viennent des touches voisines et permet de déterminer les touches qui ont été vraiment pressées par l'utilisateur.

Selon un mode de réalisation avantageux, lors de l'étape de fourniture des valeurs de taux de transmission, les valeurs de taux de transmission $T_{ij}$ sont fournies pour chaque touche $K_1$ à $K_n$, chaque valeur de taux de transmission $T_{ij}$ représentant la partie d'une force d'appui transmise d'une première touche $K_j$ à une deuxième touche $K_i$ lorsque l'utilisateur appuie sur la première touche $K_j$, les valeurs de taux de transmission $T_{ij}$ étant fournies pour j=1 à n, et i=1 à n. Le procédé permet ainsi d'éliminer les forces parasites appliquées à un capteur qui viennent de toutes les autres touches et permet de déterminer très précisément les touches qui ont été vraiment pressées par l'utilisateur.

Selon un mode de réalisation avantageux, les valeurs de taux de transmission $T_{ij}$ sont incluses dans une matrice de taux de transmission T ayant la forme suivante :

$$\begin{pmatrix} T_{11} & \cdots & T_{1n} \\ \vdots & \ddots & \vdots \\ T_{n1} & \cdots & T_{nn} \end{pmatrix}$$

et les valeurs $F_1$ à $F_n$ représentant une force d'appui appliquée par l'utilisateur aux touches du dispositif multitouches (1) sont déterminées en utilisant la formule suivante où l'inverse de la matrice de taux de transmission $T^{-1}$ est multipliée par un vecteur des valeurs $F'_1$ à $F'_n$ représentant la force appliquée aux capteurs de force $C_1$ à $C_n$ :

$$\begin{pmatrix} F_1 \\ \vdots \\ F_n \end{pmatrix} = \begin{pmatrix} T_{11} & \cdots & T_{1n} \\ \vdots & \ddots & \vdots \\ T_{n1} & \cdots & T_{nn} \end{pmatrix}^{-1} \cdot \begin{pmatrix} F'_1 \\ \vdots \\ F'_n \end{pmatrix}.$$

L'utilisation d'une matrice permet d'effectuer des calculs plus rapidement.

De manière avantageuse, les valeurs de taux de transmission $T_{ij}$ fournies dépendent notamment de la distance entre les touches. Il est ainsi possible de fournir des valeurs de taux de transmission $T_{ij}$ pour des touches voisines, et pour des touches éloignées l'une de l'autre, d'attribuer une valeur de zéro aux valeurs de taux de transmission $T_{ij}$ afin de rendre les calculs du dispositif multitouches moins intensifs.

De manière très avantageuse, les valeurs de taux de transmission $T_{ij}$ sont fixées à zéro pour des touches qui sont séparées par une distance supérieure à une distance prédéterminé. Il est ainsi possible de rendre les calculs du dispositif multitouches moins intensifs.

Selon un mode de réalisation avantageux, les valeurs de taux de transmission $T_{ij}$ sont fixées à zéro pour des touches qui sont séparées par au moins une touche intercalaire, ou au moins deux touches intercalaires. Il est ainsi possible de rendre les calculs du dispositif multitouches moins intensifs.

Selon un mode de réalisation avantageux, les valeurs de taux de transmission $T_{ij}$ sont des valeurs mesurées ou des valeurs théoriquement calculées par simulation numérique. Ceci permet de calculer très précisément les valeurs $F_1$ à $F_n$.

Selon un autre mode de réalisation avantageux, le capteur de force est un capteur ayant une résistance sensible à une force appliquée FSR.

Selon un autre mode de réalisation avantageux, le dispositif multitouche inclut un support comprenant une première et une deuxième surface, et des surfaces d'appui des touches sont situées sur la première surface, et une force est appliquée à la pluralité de capteurs de force par l'intermédiaire de la deuxième surface.

Selon un deuxième aspect, la présente invention concerne un produit programme d'ordinateur selon la revendication 8.

BREVE DESCRIPTION DES FIGURES

D'autres caractéristiques et avantages de la présente invention apparaîtront plus clairement à la lecture de la description détaillée qui suit de modes de réalisation de l'invention donnés à titre d'exemples nullement limitatifs et illustrés par les dessins annexés, dans lesquels :

- la Figure 1 illustre un dispositif multitouches ayant neuf touches dans lequel un mode de réalisation de l'invention est présentée ;
- la Figure 2 illustre un dispositif multitouches ayant trois touches dans lequel un mode de réalisation de l'invention est présentée ; et
- la Figure 3 montre des étapes du procédé selon un mode de réalisation de la présente invention.

DESCRIPTION DETAILLEE DE L'INVENTION

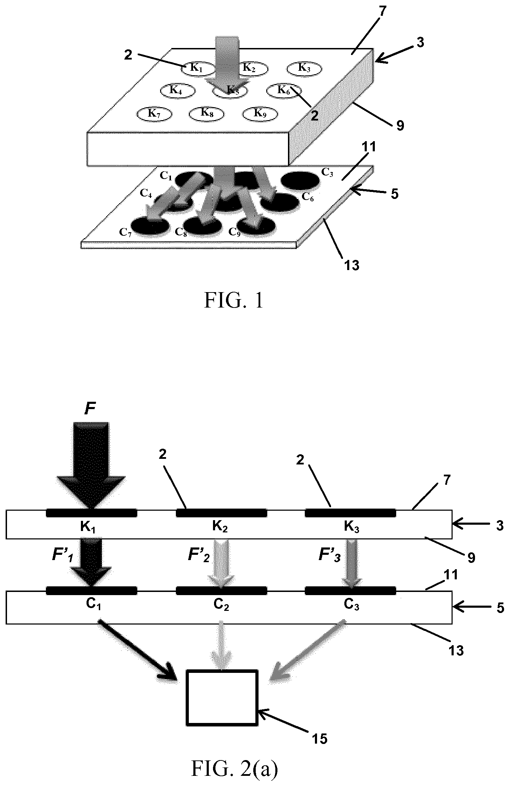

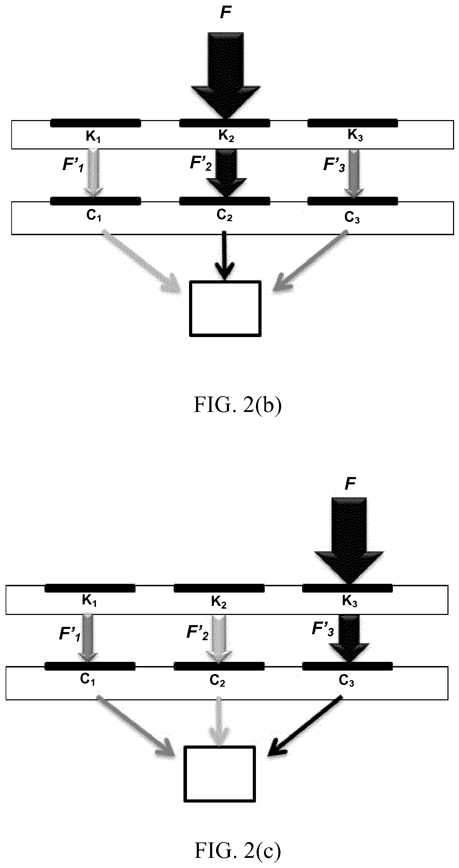

L'invention sera décrite ci-après uniquement à titre d'exemples non limitatifs en relation avec les Figures. Les Figures 1, 2(a), (b) et (c) illustrent un dispositif multitouches dans lequel un mode de réalisation de l'invention est présentée.

La Figure 1 illustre un dispositif multitouches 1 comprenant une pluralité de touches K incluant chacune une surface d'appui 2 sur laquelle un utilisateur place son doigt pour appuyer et actionner la touche.

Le dispositif multitouches 1 comprend les touches $K_1$ à $K_n$ où n=9 et une pluralité de capteurs de force $C_1$ à $C_n$ où n=9. Chacune des touches $K_1$ à $K_9$ est associée à un capteur de force parmi la pluralité des capteurs de force $C_1$ à $C_9$ et lorsqu'un utilisateur appuie sur une touche K, c'est le capteur de force C associé à cette touche K qui reçoit principalement la force d'appui de l'utilisateur et fournit un signal indiquant que sa touche K associée a été pressée.

Dans le dispositif multitouches 1 illustré sur la Figure 1, les touches $K_1$ à $K_9$ sont respectivement associées aux capteurs de force $C_1$ à $C_9$, c'est-à-dire, la touche $K_1$ est associée au capteur de force $C_1$, la touche $K_2$ est associée au capteur de force $C_2$ etc.

Le dispositif multitouche 1 comprend un premier support 3 et un deuxième support 5. Le premier support 3 inclut une première surface 7 et une deuxième surface 9, et le deuxième support 5 inclut une première surface 11 et une deuxième surface 13. Les surfaces d'appui 2 sont situées sur la première surface 7 qui est une surface extérieure visible à l'utilisateur et les capteurs de force $C_1$ à $C_9$ sont situés à l'intérieur du dispositif 1 sur la première surface 11 du deuxième support 5 et en face de la deuxième surface 9 du premier support 3.

Le premier support 3 et le deuxième support 5 sont illustrés séparés dans les Figures pour faciliter la compréhension de la présente invention, mais en réalité, la deuxième surface 9 du premier support 3 est en contact directement, ou indirectement par l'intermédiaire d'un substrat flexible, avec la pluralité des capteurs de force $C_1$ à $C_9$. Facultativement, un autre substrat flexible peut être présent entre la pluralité des capteurs de force $C_1$ à $C_9$ et la première surface 11 du deuxième support 5. De plus, le premier support 3 peut être relié au deuxième support 5 d'une telle manière à appliquer une force prédéterminée à la pluralité des capteurs de force $C_1$ à $C_9$, et le dispositif 1 est ainsi dans un état pré-chargé.

Chaque capteur de force C comprend une couche FSR ayant une résistance sensible à une force appliquée (en anglais Force Sensitive Resistor) et une première et une deuxième trace conductrice électriquement (non-illustré) en contact direct avec la couche. Lorsqu'une force est appliquée à un capteur, par exemple par un utilisateur appuyant sur sa touche associée, un court-circuit est formé entre la première et la deuxième trace, et en outre la résistance de la couche change (par, exemple, elle diminue) si bien que la résistance électrique entre la première et la deuxième trace change également (par, exemple, elle diminue).

Alternativement, d'autres capteurs de force tels que ceux utilisant une variation de la capacité électrique ou l'intensité d'une onde électromagnétique peuvent être utilisés.

Un signal représentant la valeur de la résistance électrique entre la première et la deuxième trace est reçu par un microcontrôleur 15 (Figure 2) du dispositif 1 qui est raccordé à chaque capteur de force $C_1$ à $C_9$. Le microcontrôleur 15 est configuré pour traiter ce signal reçu afin de déterminer si l'utilisateur a appuyé sur une touche K. Le dispositif 1 inclut une mémoire (non-illustrée) contenant au moins un programme/algorithme qui est mis en oeuvre par le microcontrôleur 15 pour traiter le signal reçu afin de déterminer si une touche K a été pressée.

Comme illustré sur la Figure 2(a), lorsque l'utilisateur applique une force d'appui $F$ sur une touche K, par exemple, la touche $K_1$, une force $F'_1$ est appliqué au capteur de force $C_1$. La force $F'_1$ appliquée au capteur de force $C_1$ modifie la valeur de résistance et le signal délivré au microcontrôleur 15, et le microcontrôleur 15 détermine, sur la base du changement de cette valeur, que la touche $K_1$ a été pressée par l'utilisateur.

Les Figures 2(a), (b) et (c) illustrent un dispositif multitouches identique au dispositif illustré dans la Figure 1 mais qui n'inclut que trois touches $K_1$, $K_2$ et $K_3$ afin de faciliter la compréhension de la présente invention.

Lorsque l'utilisateur applique une force d'appui $F$ sur la touche $K_1$, une force $F'_1$ est non seulement appliquée au capteur de force $C_1$ mais une force $F'_2$ et une force $F'_3$ sont simultanément appliquées aux capteurs de force $C_2$ et $C_3$ respectivement car le premier support 3 est déplacé vers le deuxième support 5 lors de l'appui de l'utilisateur. Une partie de la force $F$ appliquée sur la touche $K_1$ est transmise aux touches voisines si bien qu'une force est appliquée aux capteurs de force $C_2$ et $C_3$ par l'intermédiaire de la deuxième surface 9 du premier support 3. Ceci arrive également lorsque l'utilisateur applique une force d'appui $F$ sur la touche $K_2$ et une force d'appui $F$ sur la touche $K_3$, tel qu'illustré dans les Figures 2 (b) et 2 (c).

Comme précédemment mentionné, lorsque l'utilisateur appuie fortement et/ou pendant longtemps sur la touche $K_1$, le microcontrôleur 15 reçoit des valeurs des résistances de chacun des capteurs de force $C_1$ à $C_3$ signalant un changement de valeur de résistance et il pourrait déterminer incorrectement que l'utilisateur a appuyé sur les touches $K_1$ et $K_2$, ou chacune des trois touches $K_1$, $K_2$ et $K_3$.

En outre, lorsque l'utilisateur appuie sur les touches $K_1$ et $K_3$, le microcontrôleur 15 reçoit une valeur de résistance du capteur de force $C_2$ signalant un changement de valeur de résistance et il pourrait déterminer incorrectement, par exemple, que l'utilisateur a appuyé sur chacune des trois touches $K_1$, $K_2$ et $K_3$.

Le microcontrôleur 15 du dispositif 1 est configuré pour mettre en oeuvre un procédé (ou un algorithme) selon la présente invention pour déterminer si une ou plusieurs touches ont été activées. Le procédé permet de déterminer la touche sur laquelle l'utilisateur a vraiment appuyé, ou les touches sur lesquelles l'utilisateur a vraiment appuyé.

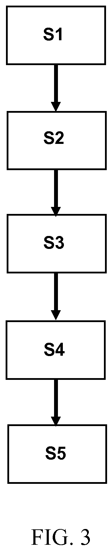

Ce procédé selon la présente invention comprend une étape S1 consistant à obtenir (Figure 3), à partir de chacun des capteurs de force $C_1$ à $C_3$, des valeurs $F'_1$ à $F'_3$ représentant la force appliquée aux capteurs de force $C_1$ à $C_3$.

Le procédé comprend en outre une étape S2 consistant à fournir des valeurs de taux de transmission $T_{ij}$ d'une force d'appui entre des touches. L'étape consiste à fournir des valeurs de taux de transmission $T_{ij}$ pour chaque touche $K_1$, $K_2$ et $K_3$ où chaque valeur de taux de transmission $T_{ij}$ représente la partie d'une force transmise, machinalement ou involontairement, d'une première touche $K_j$ à une deuxième touche $K_i$, lorsque l'utilisateur appuie sur la première touche $K_j$. Par exemple, dans Figure 2(a), la valeur de taux de transmission $T_{21}$ représente la partie de la force $F$ transmise de la touche $K_1$ à la touche $K_2$ et qui produit la force $F'_2$ appliquée au capteur de force $C_2$ ; et la valeur de taux de transmission $T_{31}$ représente la partie de la force $F$ transmise de la touche $K_1$ à la touche $K_3$ et qui produit la force $F'_3$ appliquée au capteur de force $C_3$.

Dans cette étape S2, les valeurs de taux de transmission $T_{ij}$ sont fournis pour j=1 à 3, et i=1 à 3 ; à savoir, les valeurs de taux de transmission $T_{11}$, $T_{21}$, $T_{31}$ (correspondant à la situation illustrée dans la Figure 2(a)), $T_{12}$, $T_{22}$, $T_{23}$ (correspondant à la situation illustrée dans la Figure 2(b)) et $T_{31}$, $T_{32}$, $T_{33}$ correspondant à la situation illustrée dans la Figure 2(c)) sont fournis.

Dans une variante de la présente invention, les valeurs de taux de transmission $T_{ij}$ pour des touches éloignées l'une de l'autre (par une distance supérieure à une distance prédéterminée ou par au moins une, au moins deux ou plusieurs touches intercalaires) se voient attribuer une valeur de zéro (0) afin de rendre les calculs du dispositif 1 moins intensifs. Par exemple, pour le dispositif 1 illustré dans les Figures 2(a), (b) et (c), $T_{31}=0$ et $T_{13}=0$.

Le procédé comprend en outre une étape S3 consistant à supprimer la contribution, de chacune des valeurs de forces $F'_1$ à $F'_n$, issue de la force d'appui $F$ transmise entre les touches K, en utilisant les valeurs de taux de transmission $T_{ij}$ fournies. La contribution aux valeurs des forces $F'_1$, $F'_2$ et $F'_3$ venant de la force d'appui transmise par les touches $K_1$ à $K_3$ est supprimé, en utilisant les valeurs de taux de transmission $T_{ij}$.

Le procédé comprend en outre une étape S4 consistant à déterminer des valeurs $F_1$ à $F_3$ représentant la force d'appui qui a été vraiment appliquée par l'utilisateur aux touches $K_1$ à $K_3$ et indiquant les touches $K_1$ à $K_3$ que l'utilisateur a physiquement touchées ou pressées.

Le procédé comprend en outre une étape S5 consistant à déterminer la ou les touches activées sur la base des valeurs $F_1$ à $F_3$ déterminées.

Le procédé peut optionnellement comprendre en outre une étape S6 consistant à fournir les valeurs $F_1$ à $F_3$ représentant la force d'appui qui a été vraiment appliquée par l'utilisateur aux touches $K_1$ à $K_3$ à un autre algorithme stocké dans le dispositif 1 afin d'utiliser ce résultat pour mettre en oeuvre une application ou effectuer une action.

Par exemple, selon la présente invention, pour la situation illustrée dans la Figure 2(a), la contribution à chacune des forces $F'_2$ et $F'_3$, venant de la force transmise, suite à l'appui de la force $F$ à la touche $K_1$, est supprimée si bien que uniquement la valeur $F_1$ des valeurs $F_1$ à $F_3$ représentant la force d'appui qui a été vraiment appliquée par l'utilisateur aux touches $K_1$ à $K_3$ aura une valeur importante indiquant que uniquement la touche $K_1$ a été pressée par l'utilisateur.

Les valeurs de taux de transmission $T_{ij}$ sont des valeurs mesurées (par exemple, en mesurant les forces appliquées aux capteurs lorsqu'on appuie sur chacune des touches) ou sont des valeurs théoriquement calculées par simulation numérique. Les valeurs de taux de transmission $T_{ij}$ sont incluses dans une matrice T de taux de transmission ayant la forme suivante (où n est le nombre des touches du dispositif 1) :

$$\begin{pmatrix} T_{11} & \cdots & T_{1n} \\ \vdots & \ddots & \vdots \\ T_{n1} & \cdots & T_{nn} \end{pmatrix}.$$

Un vecteur des valeurs $F'_1$ à $F'_n$ représentant les forces appliquées aux capteurs de force $C_1$ à $C_n$ lorsqu'une force $F$ est appliquée aux touches du dispositif 1 est donné par la formule suivante où la matrice de taux de transmission T est multipliée par un vecteur des valeurs $F_1$ à $F_n$ représentant les forces appliquées aux touches du dispositif 1 :

$$\begin{pmatrix} F'_1 \\ \vdots \\ F'_n \end{pmatrix} = \begin{pmatrix} T_{11} & \cdots & T_{1n} \\ \vdots & \ddots & \vdots \\ T_{n1} & \cdots & T_{nn} \end{pmatrix} \cdot \begin{pmatrix} F_1 \\ \vdots \\ F_n \end{pmatrix}.$$

Les valeurs $F_1$ à $F_n$ représentant la force d'appui que l'utilisateur a vraiment appliquée aux touche $K_1$ à $K_n$ et indiquant les touches $K_1$ à $K_3$ que l'utilisateur a physiquement touchées ou pressées sont déterminées en utilisant la formule suivante où l'inverse de la matrice de taux de transmission $T^{-1}$ est multipliée par le vecteur des valeurs $F'_1$ à $F'_n$ représentant les forces appliquées aux capteurs de force $C_1$ à $C_n$:

$$\begin{pmatrix} F_1 \\ \vdots \\ F_n \end{pmatrix} = \begin{pmatrix} T_{11} & \cdots & T_{1n} \\ \vdots & \ddots & \vdots \\ T_{n1} & \cdots & T_{nn} \end{pmatrix}^{-1} \cdot \begin{pmatrix} F'_1 \\ \vdots \\ F'_n \end{pmatrix}.$$

Par exemple, pour le dispositif 1 ayant trois touches 2 tel que illustré dans les Figures 2(a), 2(b) et 2(c), si 50% de la force $F$ est transmise au capteur $C_1$, 20% au capteur $C_2$ et 5% au capteur $C_3$ lorsque l'utilisateur presse sur la touche $K_1$ avec une force $F$; et 25% de la force $F$ est transmise au capteur $C_1$, 50% au capteur $C_2$ et 25% au capteur $C_3$ lorsque l'utilisateur presse sur la touche $K_2$ avec une force $F$; et si 5% de la force $F$ est transmise au capteur $C_1$, 30% au capteur $C_2$ et 50% au capteur $C_3$ lorsque l'utilisateur presse sur la touche $K_3$ avec une force $F$, la matrice T 3x3 de taux de transmission résultante est la suivante :

0,5 0,25 0,05
0,2 0,50 0,3
0,05 0,25 0,5

et l'inverse de la 3x3 matrice de taux de transmission $T^{-1}$ est :

2,59 -1,67 0,74
-1,26 3,67 -2,07
0,37 -1,67 2,96.

Lorsque l'utilisateur presse sur la touche $K_1$ et ensuite sur la touche $K_3$ (situation de la Figure 2(a) et 2(c)), une force est appliquée à chacun des trois capteurs $C_1$ à $C_3$ et un microcontrôleur 15 de l'état de la technique pourrait déterminer incorrectement que l'utilisateur a appuyé sur chacune des trois touches $K_1$, $K_2$ et $K_3$. La présente invention permet d'éviter une telle erreur et de fournir des valeurs $F_1$ à $F_n$ indiquant les touches $K_1$ à $K_3$ que l'utilisateur a vraiment pressées.

Si les valeurs mesurées $F'_1$ à $F'_3$ représentant les forces appliquées aux capteurs de force $C_1$ à $C_3$ sont, par exemple, $F'_1$=1,2N, $F'_2$=1,6N et $F'_3$=2,1 N, le vecteur des valeurs $F'_1$ à $F'_3$ représentant les forces appliquées aux capteurs de force $C_1$ à $C_n$ est F' = {1,2N ; 1,6N ; 2,1N}. Les valeurs $F_1$ à $F_3$ représentant la force d'appui que l'utilisateur a appliquée aux touches $K_1$ à $K_3$ sont déterminées comme indiqué ci-dessous, en appliquant la formule :

$$\begin{pmatrix} F_1 \\ \vdots \\ F_n \end{pmatrix} = \begin{pmatrix} T_{11} & \cdots & T_{1n} \\ \vdots & \ddots & \vdots \\ T_{n1} & \cdots & T_{nn} \end{pmatrix}^{-1} \cdot \begin{pmatrix} F'_1 \\ \vdots \\ F'_n \end{pmatrix}$$

- La force $F_1$ sur la touche $K_1$ est: 2,59*1,2N - 1,67*1,6N + 0,77*2,1N = 2N ;
- La force $F_2$ sur la touche $K_2$ est: -1,26*1,2N + 3,67*1,6N - 2,07*2,1N = 0N ; et
- La force $F_3$ sur la touche $K_3$ est: 0,37*1,2N - 1,67*1,6N + 2,96*2,1N = 4N.

Le microcontrôleur 15 de l'état de la technique aurait interprété que les valeurs $F'_1$=1,2N, $F'_2$=1,6N et $F'_3$=2,1N signalent que la touche $K_3$ a uniquement été pressée (puisque la valeur $F'_3$ est la valeur maximum) ou que les touches $K_2$ et $K_3$ ou $K_1$, $K_2$ et $K_3$ ont été pressées. En revanche, grâce au procédé de la présente invention, le microcontrôleur 15 déterminera que la touche $K_1$ et la touche $K_3$ ont été pressées/activées et que la touche $K_2$ n'a pas été pressée/activée. Le procédé selon la présente invention permet ainsi de correctement identifier toutes les touches pressées/activées lorsqu'un utilisateur appuie sur de multiples touches 2.

En outre, lorsque l'utilisateur a appuyé fortement et/ou pendant longtemps sur une touche, par exemple, $K_1$, le procédé selon la présente invention permet également de déterminer les valeurs $F_1$ à $F_3$ comme indiqué ci-dessus, et de correctement identifier que la touche $K_1$ a été pressée.

La présente invention concerne aussi un produit programme d'ordinateur pour une unité de traitement, tel que le microcontrôleur 15, enregistré sur un support et comprenant des portions de code de logiciel lisibles par l'unité de traitement pour exécuter les étapes du procédé.

On comprendra que diverses modifications et / ou améliorations évidentes pour l'homme du métier peuvent être apportées aux différents modes de réalisation de l'invention décrits dans la présente description sans sortir du cadre de l'invention défini par les revendications annexées.

**Revendications**

1. Procédé pour déterminer l'activation d'au moins une touche (K) d'un dispositif multitouches (1), le dispositif multitouches (1) comprenant une pluralité de touches $K_1$ à $K_n$ et une pluralité de capteurs de force $C_1$ à $C_n$, chaque capteur de force $C_1$ à $C_n$ étant associé respectivement à une touche $K_1$ à $K_n$ et apte à fournir une valeur ($F$) représentant une force qui lui est appliquée, le procédé comprenant les étapes qui consistent à :

   - obtenir des valeurs $F'_1$ à $F'_n$ représentant la force ($F$) appliquée à chacun des capteurs de force $C_1$ à $C_n$ ;
   - déterminer des valeurs $F_1$ à $F_n$ représentant la force d'appui qui a été appliquée par l'utilisateur aux touches $K_1$ à $K_n$ ;

   **caractérisé en ce que** le procédé comprend de plus les étapes consistant à :

   - fournir des valeurs de taux de transmission ($T_{ij}$) d'une force d'appui entre des touches (K) ;
   - supprimer la contribution de chacune des valeurs de forces $F'_1$ à $F'_n$ issue de la force d'appui ($F$) transmise entre les touches (K) en utilisant les valeurs de taux de transmission ($T_{ij}$) fournies ; et

   lors de l'étape de fourniture des valeurs de taux de transmission ($T_{ij}$), les valeurs de taux de transmission $T_{ij}$ sont fournies pour chaque touche $K_1$ à $K_n$, chaque valeur de taux de transmission $T_{ij}$ représentant la partie d'une force d'appui ($F$) transmise d'une première touche $K_j$ à une deuxième touche $K_i$ lorsque l'utilisateur appuie sur la première touche $K_j$, les valeurs de taux de transmission $T_{ij}$ étant fournies pour j=1 à n, et i=1 à n ; et
   dans lequel les valeurs de taux de transmission $T_{ij}$ sont incluses dans une matrice de taux de transmission (T) ayant la forme suivante :

$$\begin{pmatrix} T_{11} & \cdots & T_{1n} \\ \vdots & \ddots & \vdots \\ T_{n1} & \cdots & T_{nn} \end{pmatrix}$$

   et les valeurs $F_1$ à $F_n$ représentant une force d'appui appliquée par l'utilisateur aux touches (K) du dispositif multitouches (1) sont déterminées en utilisant la formule suivante où l'inverse de la matrice de taux de transmission ($T^{-1}$) est multipliée par un vecteur des valeurs $F'_1$ à $F'_n$ représentant la force appliquée aux capteurs de force $C_1$ à $C_n$ :

$$\begin{pmatrix} F_1 \\ \vdots \\ F_n \end{pmatrix} = \begin{pmatrix} T_{11} & \cdots & T_{1n} \\ \vdots & \ddots & \vdots \\ T_{n1} & \cdots & T_{nn} \end{pmatrix}^{-1} \cdot \begin{pmatrix} F'_1 \\ \vdots \\ F'_n \end{pmatrix}.$$

2. Procédé selon l'une quelconque des revendications 1, **caractérisé en ce que** les valeurs de taux de transmission $T_{ij}$ fournies dépendent notamment de la distance entre les touches (K).

3. Procédé selon l'une quelconque des revendications 1 à 2, **caractérisé en ce que** les valeurs de taux de transmission $T_{ij}$ sont fixées à zéro pour des touches (K) qui sont séparées par une distance supérieure à une distance prédéterminé.

4. Procédé selon l'une quelconque des revendications 1 à 2, **caractérisé en ce que** les valeurs de taux de transmission $T_{ij}$ sont fixées à zéro pour des touches (K) qui sont séparées par au moins une touche intercalaire, ou au moins deux touches intercalaires.

**5.** Procédé selon l'une quelconque des revendications 1 à 2, **caractérisé en ce que** les valeurs de taux de transmission ($T_{ij}$) sont des valeurs mesurées ou des valeurs théoriquement calculées par simulation numérique.

**6.** Procédé selon l'une quelconque des revendications 1 à 5, **caractérisé en ce que** le capteur de force (C) est un capteur ayant une résistance sensible à une force appliquée (FSR).

**7.** Procédé selon l'une quelconque des revendications 1 à 6, **caractérisé en ce que** le dispositif multitouche (1) inclut un support (3) comprenant une première (7) et une deuxième surface (9), et des surfaces d'appui (2) des touches (K) sont situées sur la première surface (7), et une force est appliquée à la pluralité de capteurs de force (C) par l'intermédiaire de la deuxième surface (9).

**8.** Produit programme d'ordinateur pour une unité de traitement (15) d'un dispositif multitouches enregistré sur un support et comprenant des portions de code de logiciel lisibles par l'unité de traitement pour exécuter les étapes du procédé selon l'une quelconque des revendications 1 à 7.

**Patentansprüche**

**1.** Verfahren zum Bestimmen der Aktivierung zumindest einer Taste (K) einer Mehrtastenvorrichtung (1), wobei die Mehrtastenvorrichtung (1) eine Mehrzahl von Tasten $K_1$ bis $K_n$ und eine Mehrzahl von Kraftsensoren $C_1$ bis $C_n$ enthält, wobei jeder Kraftsensor $C_1$ bis $C_n$ jeweils einer Taste $K_1$ bis $K_n$ zugeordnet und dazu geeignet ist, einen Wert (*F'*) bereitzustellen, der eine darauf ausgeübte Kraft darstellt, wobei das Verfahren die folgenden Schritte umfasst:

- Erhalten von Werten $F'_1$ bis $F'_n$, die die auf jeden der Kraftsensoren $C_1$ bis $C_n$ ausgeübte Kraft (*F'*) darstellen;
- Bestimmen von Werten $F_1$ bis $F'_n$, die die Andrückkraft darstellen, die von einem Benutzer auf die Tasten $K_1$ bis $K_n$ ausgeübt worden ist;

**dadurch gekennzeichnet, dass**
das Verfahren ferner die folgenden Schritte umfasst:

- Bereitstellen von Übertragungswerten ($T_{ij}$) einer Andrückkraft zwischen Tasten (K);
- Aufheben der Mitwirkung von jedem der Kraftwerte $F'_1$ bis $F'_n$, die aus der zwischen den Tasten (K) übertragenen Andrückkraft (F) stammt, unter Verwendung der bereitgestellten Übertragungswerte ($T_{ij}$); wobei beim Schritt des Bereitstellens der Übertragungswerte ($T_{ij}$) die Übertragungswerte $T_{ij}$ für jede Taste $K_1$ bis $K_n$ bereitgestellt werden, wobei jeder Übertragungswert $T_{ij}$ denjenigen Anteil einer Andrückkraft (F) darstellt, der von einer ersten Taste $K_j$ auf eine zweite Taste $K_i$ übertragen wird, wenn der Benutzer auf die erste Taste $K_j$ drückt, wobei die Übertragungswerte $T_{ij}$ bereitgestellt werden für j= 1 bis n und i = 1 bis n; und

wobei die Übertragungswerte $T_{ij}$ in einer Übertragungsgradmatrix (T) enthalten sind, die folgende Form hat:

$$\begin{pmatrix} T_{11} & \cdots & T_{1n} \\ \vdots & \ddots & \vdots \\ T_{n1} & \cdots & T_{nn} \end{pmatrix}$$

und die Werte $F_1$ bis $F'_n$, die eine von dem Benutzer auf die Tasten (K) der Mehrtastenvorrichtung (1) ausgeübte Andruckkraft darstellen, unter Verwendung der nachfolgenden Formel bestimmt werden, worin die Inverse der Übertragungsgradmatrix ($T^{-1}$) mit einem Vektor der Werte $F'_1$ bis $F'_n$ multipliziert wird, die die auf die Kraftsensoren $C_1$ bis $C_n$ ausgeübte Kraft darstellen:

$$\begin{pmatrix} F_1 \\ \vdots \\ F_n \end{pmatrix} = \begin{pmatrix} T_{11} & \cdots & T_{1n} \\ \vdots & \ddots & \vdots \\ T_{n1} & \cdots & T_{nn} \end{pmatrix}^{-1} \cdot \begin{pmatrix} F'_1 \\ \vdots \\ F'_n \end{pmatrix}$$

**2.** Verfahren nach Anspruch 1,
**dadurch gekennzeichnet, dass**

die bereitgestellten Übertragungswerte $T_{ij}$ insbesondere von der Entfernung zwischen den Tasten (K) abhängen.

3. Verfahren nach einem der Ansprüche 1 bis 2,
**dadurch gekennzeichnet, dass**
die Übertragungswerte $T_{ij}$ bei Tasten (K), die durch eine Entfernung größer als eine vorbestimmte Entfernung beabstandet sind, auf null festgelegt werden.

4. Verfahren nach einem der Ansprüche 1 bis 2,
**dadurch gekennzeichnet, dass**
die Übertragungswerte $T_{ij}$ bei Tasten (K), die durch zumindest eine Zwischentaste oder zumindest zwei Zwischentasten beabstandet sind, auf null festgelegt werden.

5. Verfahren nach einem der Ansprüche 1 bis 2,
**dadurch gekennzeichnet, dass**
die Übertragungswerte $T_{ij}$ Messwerte oder durch digitale Simulation theoretisch berechnete Werte sind.

6. Verfahren nach einem der Ansprüche 1 bis 5,
**dadurch gekennzeichnet, dass**
der Kraftsensor (C) ein Sensor mit einem gegenüber der ausgeübten Kraft empfindlichen Widerstand (FSR) ist.

7. Verfahren nach einem der Ansprüche 1 bis 6,
**dadurch gekennzeichnet, dass**
die Mehrtastenvorrichtung (1) einen Träger (3) umfasst, der eine erste (7) und eine zweite Fläche (9) aufweist, wobei sich an der ersten Fläche (7) Andrückflächen (2) der Tasten (K) befinden und über die zweite Fläche (9) eine Kraft auf die Mehrzahl von Kraftsensoren (C) ausgeübt wird.

8. Computerprogrammprodukt für eine Verarbeitungseinheit (15) einer Mehrtastenvorrichtung, das auf einen Träger aufgezeichnet ist und Software-Codeabschnitte enthält, die von der Verarbeitungseinheit eingelesen werden können, um die Schritte des Verfahrens nach einem der Ansprüche 1 bis 7 auszuführen.

**Claims**

1. Method for determining the activation of at least one key (K) of a multikey device (1), the multikey device (1) comprising a plurality of keys $K_1$ to $K_n$ and a plurality of force sensors $C_1$ to $C_n$, each force sensor $C_1$ to $C_n$ being associated respectively with a key $K_1$ to $K_n$ and able to provide a value (F') representing a force which is applied to it, the method comprising the steps which consist in:

- obtaining values $F'_1$ to $F'_n$ representing the force (F') applied to each of the force sensors $C_1$ to $C_n$;
- determining values $F_1$ to $F_n$ representing the bearing force which has been applied by the user to the keys $K_1$ to $K_n$;

**characterized in that** the method furthermore comprises the steps consisting in:

- providing values of rate of transmission ($T_{ij}$) of a bearing force between keys (K);
- removing the contribution of each of the values of forces $F'_1$ to $F'_n$ arising from the bearing force (F) transmitted between the keys (K) by using the transmission rate values ($T_{ij}$) provided; and

during the step of providing the transmission rate values ($T_{ij}$), the transmission rate values $T_{ij}$ are provided for each key $K_1$ to $K_n$, each transmission rate value $T_{ij}$ representing the part of a bearing force (F) transmitted from a first key $K_j$ to a second key $K_i$ when the user presses the first key $K_j$, the transmission rate values $T_{ij}$ being provided for j=1 to n, and i=1 to n; and
in which the transmission rate values $T_{ij}$ are included in a transmission rate matrix (T) having the following form:

$$\begin{pmatrix} T_{11} & \cdots & T_{1n} \\ \vdots & \ddots & \vdots \\ T_{n1} & \cdots & T_{nn} \end{pmatrix}$$

and the values $F_1$ to $F_n$ representing a bearing force applied by the user to the keys (K) of the multikey device (1) are determined by using the following formula where the inverse of the transmission rate matrix ($T^{-1}$) is multiplied by a vector of the values $F'_1$ to $F'_n$ representing the force applied to the force sensors $C_1$ to $C_n$:

$$\begin{pmatrix} F_1 \\ \vdots \\ F_n \end{pmatrix} = \begin{pmatrix} T_{11} & \cdots & T_{1n} \\ \vdots & \ddots & \vdots \\ T_{n1} & \cdots & T_{nn} \end{pmatrix}^{-1} \cdot \begin{pmatrix} F'_1 \\ \vdots \\ F'_n \end{pmatrix}.$$

2. Method according to any one of Claims 1, **characterized in that** the transmission rate values $T_{ij}$ provided depend in particular on the distance between the keys (K).

3. Method according to any one of Claims 1 to 2, **characterized in that** the transmission rate values $T_{ij}$ are fixed at zero for keys (K) which are separated by a distance greater than a predetermined distance.

4. Method according to any one of Claims 1 to 2, **characterized in that** the transmission rate values $T_{ij}$ are fixed at zero for keys (K) which are separated by at least one intercalary key, or at least two intercalary keys.

5. Method according to any one of Claims 1 to 2, **characterized in that** the transmission rate values ($T_{ij}$) are measured values or values calculated theoretically by numerical simulation.

6. Method according to any one of Claims 1 to 5, **characterized in that** the force sensor (C) is a sensor having an applied-force-sensitive resistance (FSR).

7. Method according to any one of Claims 1 to 6, **characterized in that** the multikey device (1) includes a support (3) comprising a first (7) and a second surface (9), and bearing surfaces (2) of the keys (K) are situated on the first surface (7), and a force is applied to the plurality of force sensors (C) by way of the second surface (9).

8. Computer program product for a processing unit (15) of a multikey device recorded on a support and comprising software code portions readable by the processing unit to execute the steps of the method according to any one of Claims 1 to 7.

FIG. 1

FIG. 2(a)

FIG. 2(b)

FIG. 2(c)

FIG. 3

**EP 2 867 748 B1**

## RÉFÉRENCES CITÉES DANS LA DESCRIPTION

**Documents brevets cités dans la description**

- WO 2012004370 A1
- US 2009066673 A1